**Europäisches Patentamt**

**European Patent Office**

**Office européen des brevets**

(19)

(11) Numéro de publication : **0 012 093**
**B1**

(12) # FASCICULE DE BREVET EUROPÉEN

(45) Date de publication du fascicule du brevet :
28.04.82

(51) Int. Cl.³ : **H 03 F   1/18**

(21) Numéro de dépôt : **79400961.3**

(22) Date de dépôt : **04.12.79**

(54) **Amplificateur distribué pour hyperfréquences, et dispositif d'amplification comportant un tel amplificateur.**

(30) Priorité : **05.12.78 FR 7834224**

(43) Date de publication de la demande :
**11.06.80 (Bulletin 80/12)**

(45) Mention de la délivrance du brevet :
**28.04.82 Bulletin 82/17**

(84) Etats contractants désignés :
**DE GB IT NL**

(56) Documents cités :
**DE - A - 2 460 522**
**FR - A - 1 466 827**
**FR - A - 2 367 378**
**US - A - 3 495 183**
**PROCEEDINGS OF THE INSTITUTE OF ELECTRI-**
**CAL AND ELECTRONIC ENGINEERS, vol. 57,**
**n° 6, juin'69 New York (US) « A MESFET distribu-**
**ted Amplifier with 2 GHZ Bandwidth », pages**
**1195-1196.**
**ELECTRONICS, vol. 44, n° 6, 15 mars 1971., New**
**York (US), « MOSFETS rejuvenate old design for**
**CATV broadband amplifiers », pages 72-75.**

(73) Titulaire : **THOMSON-CSF**
**173, Boulevard Haussmann**
**F-75360 Paris Cedex 08 (FR)**

(72) Inventeur : **Bert, Alain**
**"THOMSON-CSF" - SCPI 173, bld Haussmann**
**F-75360 Paris Cedex 08 (FR)**
Inventeur : **Kaminsky, Didier**
**"THOMSON-CSF" - SCPI 173, bld Haussmann**
**F-75360 Paris Cedex 08 (FR)**
Inventeur : **Kantorowicz, Gérard**
**"THOMSON-CSF" - SCPI 173, bld Haussmann**
**F-75360 Paris Cedex 08 (FR)**

(74) Mandataire : **Benichou, Robert et al**
**"THOMSON-CSF" - SCPI 173 bld Haussmann**
**F-75360 Paris Cedex. 08 (FR)**

Imprimerie Jouve, 18, rue St-Denis, 75001 Paris, France

EP 0 012 093 B1

# Amplificateur distribué pour hyperfréquences, et dispositif d'amplification comportant un tel amplificateur

La présente invention concerne un amplificateur distribué pour hyperfréquences et le dispositif d'amplification incorporant un tel amplificateur.

Les amplificateurs distribués sont constitués de façon générale, de deux lignes de transmission, d'entrée et de sortie, reliées par des éléments amplificateurs, ou quadripôles actifs, qui sont tous montés en parallèle par deux de leurs pôles sur la ligne d'entrée et par leurs deux autres pôles sur la ligne de sortie. La puissance à amplifier, injectée à l'entrée de la première ligne, se répartit entre les différents amplificateurs, dont les puissances de sortie se recombinent pour donner une puissance amplifiée à la sortie de la seconde ligne.

De tels amplificateurs sont connus de l'art antérieur ; les éléments amplificateurs qu'ils utilisent sont notamment des tubes électroniques ou des amplificateurs à semi-conducteur, à haute impédance d'entrée, comme les transistors à effet de champ par exemple, faciles à intégrer dans des structures de transmission pour hyperfréquences notamment dans la bande X.

De tels amplificateurs ont été décrits dans l'article de Edward L. GINZTON et al. intitulé « Distributed Amplification » paru dans la revue Proceedings of the I.R.E., vol. 36 n° 8 août 1948, ainsi que dans le brevet britannique n° 464,977. Ils ont donné lieu à des réalisations très variées, caractérisées par les dispositions adoptées pour assurer la répartition des puissances entre les amplificateurs à l'entrée et la recombinaison des puissances amplifiées à la sortie.

Dans tous les cas cependant, outre la question du gain en puissance, l'une des conditions qui domine la réalisation des amplificateurs basés sur ce principe est celle de leur bande de fréquences de fonctionnement possible, ou largeur de bande, car le fonctionnement de ces structures se dégrade vite aux fréquences voisines de la fréquence centrale pour laquelle ils sont prévus. La transformation le long des lignes des impédances de chaque dérivation change, en effet, de façon sensible avec la fréquence, ce qui fait que le réglage de l'ensemble, satisfaisant à la fréquence centrale, l'est beaucoup moins sur les fréquences voisines ; il en résulte une largeur de bande limitée.

L'invention a pour objet un amplificateur distribué utilisant une disposition qui permet notamment d'élargir, toutes choses égales par ailleurs, la bande des fréquences de fonctionnement.

Dans l'une des conceptions de l'art antérieur, les éléments amplificateurs étaient munis chacun de leurs éléments d'adaptation. Chacune des dérivations comportait un amplificateur dont on adaptait l'impédance de manière qu'il soit vu de la ligne d'entrée sur laquelle il était monté avec une impédance Zo, réelle comme l'impédance caractéristique des différents tronçons de cette ligne d'entrée ; on procédait de même pour la ligne de sortie ; ces adaptations étaient faites séparément avant montage pour chaque amplificateur du lot. Chacun d'eux, muni de ses éléments d'adaptation, était ensuite monté aux points d'insertion prévus sur l'une et l'autre lignes de transmission. Un tel genre de réalisation a été décrit en particulier par WHITE dans le brevet délivré aux Etats-Unis sous le n° 3 593 174 le 13 juillet 1971.

Il est rare, cependant, qu'en procédant de cette façon on puisse obtenir rigoureusement la valeur réelle en question et la même pour tous les amplificateurs élémentaires, en dépit de leur dispersion naturelle. Il s'ensuit que l'adaptation n'est pas parfaite, même sur la fréquence centrale, et que certaines réflexions soient inévitables dans les lignes, ce qui nuit au gain de l'amplificateur, les conditions s'aggravant lorsque l'on s'écarte de la fréquence centrale, et réduisant la bande de fonctionnement possible.

Un tel art antérieur est décrit aussi notamment dans l'article de W. JUTZI dans la revue « Proceedings of the Institute of Electrical and Electronic Engineers » vol. 57, n° 6, juin 1969, sous le titre « A MESFET Distributed Amplifier with 2 GHz Bandwith ». L'amplificateur distribué est réalisé sous forme hybride de façon à permettre le contrôle séparé des transistors (à effet de champ) et des lignes, en vue de leur adaptation les uns aux autres (voir lignes 6 et 7).

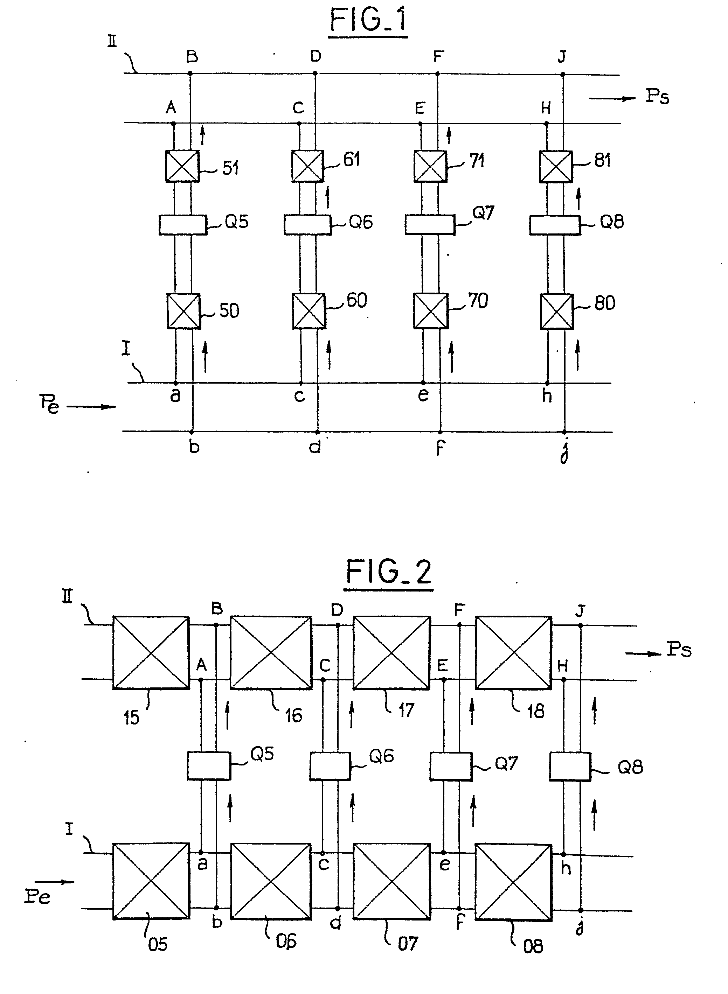

On peut dire que c'est également ce qui est fait, dans une certaine mesure, dans le dispositif d'amplification distribué du brevet DE-A-24 60 522 au nom de Siemens AG, où les dérivations de chacun des transistors comportent des éléments d'adaptation sous forme de tronçons de conducteurs, en plus des éléments d'adaptation montés dans des lignes d'entrée et de sortie elles-mêmes, bien que, dans ce cas, on puisse considérer que les tronçons en question $TL_1 - TL_8$ (figure 1) font partie de ces lignes.

Selon l'invention, les moyens d'adaptation en question sont constitués par des parties des lignes de transmission qui séparent les points d'insertion des différentes dérivations sur celles-ci, et ceci aussi bien à l'entrée qu'à la sortie, où ils forment avec les transistors des résonateurs couplés entre eux.

De cette manière, on apercevra sans que cela constitue une explication scientifique rigoureuse, que l'effet des longueurs de ligne sur les valeurs des éléments adaptateurs, en dehors de la fréquence centrale de fonctionnement notamment, puisse être moins grand que dans l'art antérieur auquel il a été fait référence.

On verra, en outre, que dans certaines formes de ces amplificateurs distribués, à l'état solide, sur un substrat semi-conducteur, la réalisation des moyens d'adaptation sur ces tronçons est particulièrement aisée sous forme intégrée.

L'invention sera mieux comprise en se reportant à la description qui suit et aux figures jointes qui représentent :

Figure 1 : un schéma montrant l'insertion des amplificateurs élémentaires dans un amplificateur distribué de l'art antérieur ;

Figure 2 : un schéma analogue au précédent pour un amplificateur distribué selon l'invention ;

Figure 3 : le schéma électrique équivalent d'un exemple d'amplificateur distribué de l'invention ;

Figure 4 : une vue en plan d'un amplificateur distribué de l'invention à l'état solide et dans la technique microbandes ;

Figure 5 : un exemple de réalisation de l'amplificateur distribué de l'invention sous forme monolithique ;

Figure 6 : une vue partielle d'une variante de réalisation de l'amplificateur de l'invention de la figure précédente.

La figure 1 montre schématiquement une portion d'un amplificateur distribué de l'art antérieur limité aux quatre quadripôles consécutifs, $Q_5 Q_6 Q_7$ et $Q_8$ par exemple.

I et II désignent respectivement les lignes d'entrée et de sortie de l'amplificateur distribué, sur lesquelles s'insèrent les dérivations portant les quadripôles, en ab, cd, ef, hj, pour la ligne d'entrée et AB, CD, EF et HJ, pour la ligne de sortie ; chaque branche ou dérivation, porte des éléments adaptateurs dont le rôle est de transformer, aussi bien à l'entrée qu'à la sortie de chacun des quadripôles, l'impédance de celui-ci en une impédance adaptée à celle de la ligne ; les impédances dont il est question sont celles apparaissant entre les points a et b, c et d, e et f, et h et j, en ce qui concerne l'entrée, et A et B, C et D, E et F, et H et J, à la sortie. Ces adaptateurs portent les repères 50 et 51, 60 et 61, 70 et 71, et 80 et 81 ; on les a représentés par des rectangles barrés d'une croix, étant entendu que l'impédance apparaissant aussi bien à l'entrée qu'à la sortie, entre les bornes telles que a, b et A, B est celle résultant de la présence de ces adaptateurs plus des longueurs de lignes qui les relient à ces bornes, qui, comme on le sait, ne peuvent pas être négligées dans le cas des hyperfréquences.

Le signal à amplifier de puissance $P_e$ est injecté à l'entrée de la ligne I, à gauche sur la figure, et se propage dans la direction de la flèche du bas de la figure, le long de cette ligne, où elle se répartit entre les différentes dérivations (flèches verticales).

Le signal amplifié puissance $P_s$ se propage dans la direction de la flèche de droite, en haut de la figure vers la sortie de la ligne II.

Suivant une disposition couramment pratiquée dans l'art antérieur, ces lignes sont elles-mêmes constituées de tronçons présentant tous une impédance purement réelle et les éléments adaptateurs sont choisis de manière que les impédances apparaissant aux points d'insertion (a, b, A, B, etc.) soient réelles également.

On voit alors que, si l'on ajoute la condition généralement admise d'une équi-répartition des puissances entre les quadripôles, qui reçoivent alors chacun la même fraction de la puissance d'entrée $P_e$, ces tronçons de ligne, c'est-à-dire les portions comprises sur la ligne I entre les points hj et ef, ef et cd, et cd et ab puis au-delà à gauche, devront présenter des impédances caractéristiques qui décroissent lorsque l'on va vers la gauche ; sur la ligne de sortie cette décroissance se produira vers la droite. Dans le cas de la figure par exemple, et en se limitant, pour permettre l'évaluation, aux quatre quadripôles représentés, et en supposant l'impédance en hj réelle et égale à 100 ohms, le tronçon de la ligne I compris entre les points hj et ef sera choisi d'impédance caractéristique égale à 100 ohms, celui compris entre ef et cd sera choisi d'une impédance caractéristique de 50 ohms seulement si l'on veut des puissances égales à l'entrée des quadripôles 8 et 7, tandis que le tronçon compris entre cd et ab sera choisi d'une impédance de 33 ohms. Le suivant serait de 25 ohms, etc. ; dans la ligne de sortie ces valeurs se répartiraient dans l'ordre inverse entre AB et CD, CD et EF, et EF et HJ. La puissance de sortie est $P_s = GP_e$, G étant la valeur du gain d'un quadripôle, sensiblement la même pour tous.

Les précisions qui précèdent ont été données pour mieux situer le problème, bien que les conditions énumérées, celle notamment de l'égalité des puissances à l'entrée de chaque quadripôle actif, ne soient pas obligatoires.

Quoi qu'il en soit la difficulté, comme déjà souligné, est de réaliser, préalablement au montage des quadripôles sur les lignes, des valeurs rigoureusement pré-établies, quelle que soit d'ailleurs la loi de décroissance dont on a donné seulement un exemple plus haut. Des écarts par rapport aux valeurs désirées entraînent des réflexions sur les lignes qui ne peuvent généralement être rattrapées, aucun moyen d'adaptation supplémentaire n'étant prévu sur ces lignes elles-mêmes.

Dans l'invention au contraire, tous les moyens d'adaptation font partie de ces lignes elles-mêmes ; ils sont ajustés lors de la construction de ces lignes. Le schéma correspondant est alors celui de la figure 2, où ces moyens d'adaptation sont incorporés dans les lignes de propagation, aussi bien à l'entrée qu'à la sortie, avec les repères 05 à 08 et 15 à 18 pour les quatre mêmes quadripôles que dans l'exemple précédent.

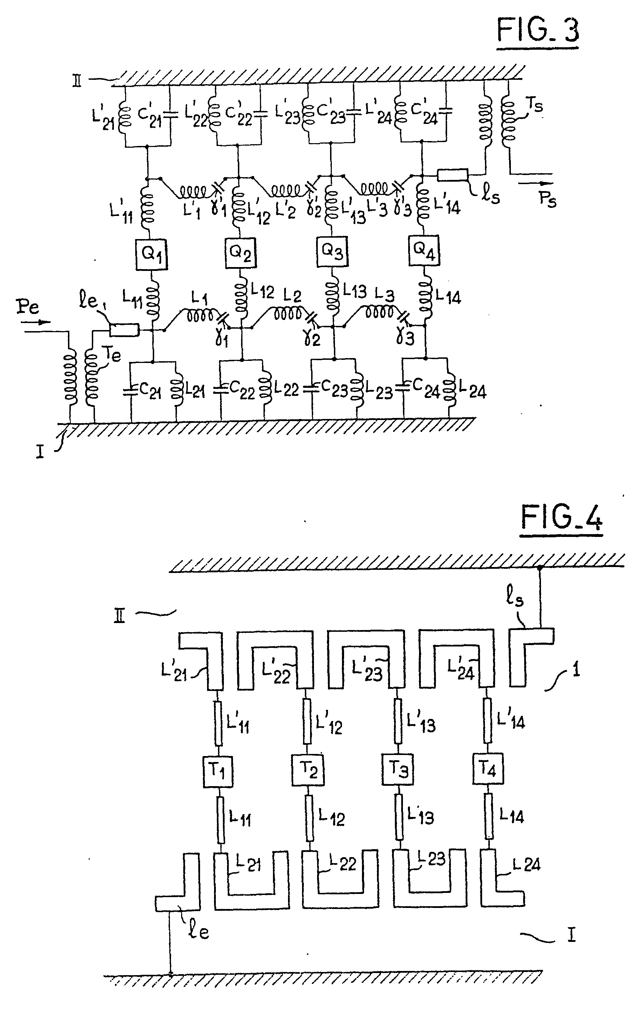

Dans les structures de l'invention, les amplificateurs élémentaires sont intégrés à des résonateurs, et ces résonateurs couplés entre eux, suivant des dispositions diverses, dont une illustration est donnée aux figures 3 et 4.

Sur ces figures, les moyens d'adaptation peuvent paraître situés en dehors des lignes de transmission I et II, contrairement à ce qui a été affirmé précédemment. Il n'en est rien en réalité, et l'on devra garder présent à l'esprit que la première de ces deux figures est un schéma électrique équivalent, dont l'objet est de montrer l'ensemble des moyens réunis dans l'invention et non leurs positions relatives exactes, et dont l'autre est un exemple de réalisation à l'état solide dans lequel les tronçons marqués L, quelle que soit leur orientation, sont des tronçons de conducteurs parties intégrantes des lignes I et II.

La figure 3 est le schéma équivalent d'un exemple d'amplificateur distribué de l'invention à quatre quadripôles. Les impédances d'entrée et de sortie des quadripôles amplificateurs de cet exemple sont équivalents à des circuits R, C, résistance capacité, comme c'est le cas pour des transistors à effet de champ. Les impédances d'entrée forment avec les éléments $L_{11}$, $L_{21}$, $C_{21}$ (pour la première cellule), $L_{12}$, $L_{22}$, $C_{22}$ (pour la deuxième cellule), $L_{13}$, $L_{23}$, $C_{23}$ (pour la troisième cellule) etc., des résonateurs qui sont couplés entre eux par les éléments $L_1$, $\gamma_1$ ..., $L_3$, $\gamma_3$. De la même façon, les impédances de sortie forment avec les éléments $L'_{11}$, $L'_{21}$, $C'_{21}$ (pour la première cellule), $L'_{12}$, $L'_{22}$, $C'_{22}$ (pour la deuxième cellule), $L'_{13}$, $L'_{23}$, $C'_{23}$ (pour la troisième cellule) etc., des résonateurs qui sont couplés entre eux par les éléments $L'_1$, $\gamma'_1$, $L'_2$, $\gamma'_2$, $L'_3$, $\gamma'_3$.

On voit en outre sur le schéma deux transformateurs d'impédance et des tronçons de ligne, symbolisés par des rectangles, qui peuvent s'avérer nécessaires, comme connu en hyperfréquence, pour adapter l'ensemble du dispositif à l'entrée et à la sortie. Ces éléments portent les repères $T_e$, $I_e$ et $T_s$, $I_s$.

La figure 4 montre un mode de réalisation d'un amplificateur distribué à quatre quadripôles de l'invention, dans une version hybride, version dans laquelle les quadripôles amplificateurs sont des transistors $T_1$, $T_2$, $T_3$, $T_4$, préparés séparément et rapportés sur un substrat isolant 1 portant les lignes, elles-mêmes réalisées suivant la technique « micro-bandes », dans laquelle ces lignes sont constituées par des tronçons de conducteurs appliqués sur une face du substrat et par les parties qui leur font vis-à-vis d'une électrode conductrice appliquée sur la face opposée de ce substrat. Si ces tronçons de conducteurs couplés entre eux ont des longueurs voisines du quart de la longueur d'onde de la fréquence centrale, on peut montrer que cette disposition est électriquement équivalente au schéma de la figure 3, chaque couplage assurant une inversion d'impédance suivant les principes connus dans l'art de la réalisation des filtres passe-bande de ce type ; ces tronçons sont reliés aux transistors par d'autres tronçons réalisés par exemple par thermo-compression, que l'on a désignés par les mêmes repères $L_{11}$ à $L_{14}$ et $L'_{11}$ à $L'_{14}$ que dans le schéma précédent. Sur la figure, les capacités des transistors n'ont pas été représentées ; elles sont incluses dans la représentation de ceux-ci. Une ligne couplée complète le dispositif aussi bien à l'entrée qu'à la sortie : repères $I_e$ et $I_s$.

On notera que la structure qui vient d'être décrite n'est pas autre chose qu'une structure à filtres passe-bande, mais où les filtres présentent cette particularité de comporter, répartis dans leur longueur, des éléments actifs, dont le premier est relié à l'entrée de chaque filtre et le dernier à la sortie. Cette structure en filtres résulte du couplage des résonateurs associés, selon l'invention, aux quadripôles actifs.

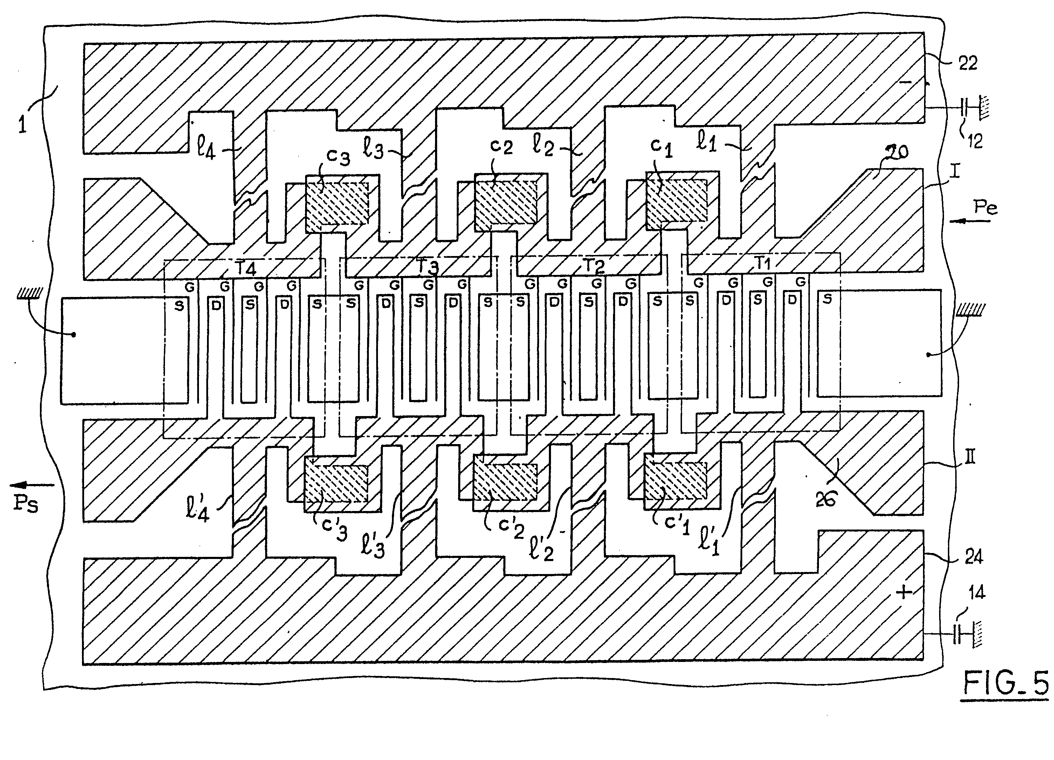

La figure 5 montre un exemple d'amplificateur hyperfréquence distribué de l'invention réalisé à l'état solide, sous forme monolithique, dans la technique micro-bandes utilisant, comme éléments des lignes, des dépôts métalliques sur substrat isolant, comme déjà précisé.

Dans cette réalisation monolithique, dont la figure est une vue en plan, les amplificateurs sont des transistors à effet de champ formés dans un substrat semi-isolant d'arséniure de gallium (AsGa), équivalents à des circuits R, C, et dont les sources, grilles et drains sont désignés respectivement par les lettres S, G et D ; ces amplificateurs sont au nombre de quatre dans l'exemple, limités aux carrés en traits mixtes, $T_1$, $T_2$, $T_3$, $T_4$.

Les grilles de ces transistors sont reliées à un premier dépôt conducteur 20, faisant partie de la ligne d'entrée I, bordant la zone d'implantation des transistors dans le substrat, et leurs drains à un second dépôt conducteur 26, faisant partie de la ligne II, bordant la zone implantée de l'autre côté. Ces dépôts consistent en des micro-bandes ou micro-rubans, comme déjà indiqué à propos de la figure précédente.

Des inductances sont réalisées sous forme de micro-rubans perpendiculaires aux précédents et en contact avec eux, s'étendant des parties 20 et 26 à deux autres parties qui leur sont parallèles, repérées 22 et 24, et qui sont les bandes de contact des lignes I et II, par lesquelles, en fonctionnement, ces lignes sont reliées aux alimentations de courant continu (non représentées) dans les conditions connues de la technique de ces circuits ; ces bandes de contact sont couplées en haute fréquence à la masse du système par les capacités 12 et 14 ; cette masse est celle d'une électrode conductrice sous-jacente au substrat, non visible sur le dessin. Les sources des transistors sont reliées à cette masse. Sur le dessin, afin de les faire bien ressortir, les parties conductrices ont été recouvertes de hachures.

Un couplage capacitif est réalisé entre les résonateurs associés à chaque amplificateur ainsi créés, en prévoyant des micro-bandes 20 et 26 interrompues en certains points entre les inductances, et réalisées dans cette partie par deux dépôts conducteurs superposés séparés par une couche d'isolant (hachures fines en pointillés). Les inductances portent sur le dessin les repères $I_1$, $I_4$ et $I'_1$ à $I'_4$, et les capacités de couplage les repères $c_1$ à $c_3$ et $c'_1$ à $c'_3$ pour les lignes d'entrée et de sortie respectivement. Pour tous ces dépôts on a utilisé la technique de la photogravure.

On a obtenu ainsi une structure monolithique couvrant sur le cristal d'arséniure de gallium une surface rectangulaire de 600 micromètres dans le sens de la propagation sur 1 200 micro-mètres dans le sens perpendiculaire, pouvant fonctionner dans une bande d'un octave autour de 8 gigahertz et délivrant une puissance supérieure au watt, avec quatre transistors à effet de champ présentant un gain de 6 dB.

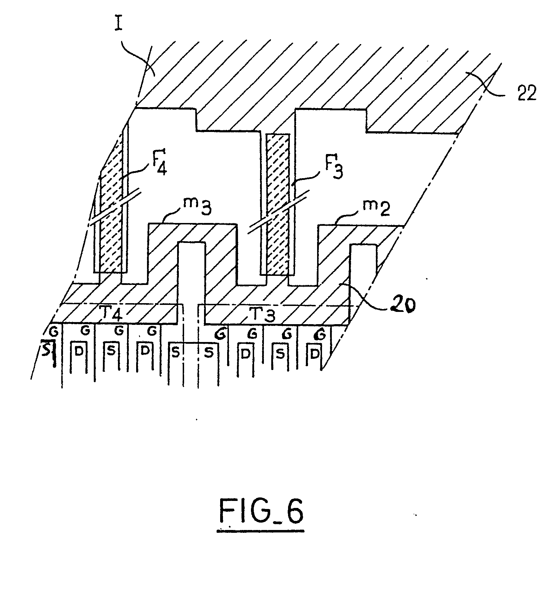

Une disposition équivalente à celle de la figure 5, également comprise dans l'invention, serait celle où la place des inductances et celle des capacités de cette figure seraient interverties, comme indiqué sur la vue partielle de la figure 6 montrant, sans indication de polarité, deux de ces inductances et deux de ces capacités.

Comme sur le dessin précédent, les capacités, repérées ici par la lettre F ($F_{3'4}$ sur la vue partielle), sont représentées par les surfaces couvertes de hachures fines en pointillés ; quant aux inductances, $m_2$, $m_3$, elles sont réalisées par des portions rentrantes du conducteur 20.

On a donné ci-dessus deux variantes de réalisation de l'amplificateur distribué de l'invention qui ont été décrites à titre non limitatif, toutes les autres variantes qui en dérivent, accessibles à l'homme de l'art, étant également comprises dans l'invention.

L'amplificateur hyperfréquence de l'invention trouve une application dans les dispositifs d'amplification de puissance de signaux électriques hyperfréquence en bande X, et dans les dispositifs d'émission réception de signaux hyperfréquence à large bande.

**Revendications**

1. Amplificateur distribué pour hyperfréquences comprenant deux lignes de transmission, d'entrée et de sortie (I, II), et une pluralité de quadripôles actifs ($Q_1$-$Q_4$) montés en dérivation par deux de leurs pôles sur la ligne d'entrée (I), et par leurs deux autres pôles sur la ligne de sortie (II), et des moyens d'adaptation des quadripôles à chacune des lignes de transmission, constitués par des parties de ces lignes elles-mêmes, caractérisé en ce que les moyens d'adaptation consistent en des réactances formant avec les quadripôles actifs des résonateurs ($C_{21}$-$C_{24}$, $L_{21}$-$L_{24}$, $L_{11}$-$L_{14}$), ($C'_{21}$-$C'_{24}$, $L'_{21}$-$L'_{24}$, $L'_{11}$-$L'_{14}$), et en des éléments de couplage entre ces résonateurs ($L_1\gamma_1$-$L_3\gamma_3$), ($L'_1\gamma'_1$-$L'_3\gamma'_3$).

2. Amplificateur distribué pour hyperfréquences suivant la revendication 1, caractérisé en ce que les quadripôles actifs consistent en des transistors à effet de champ ($T_1$-$T_4$) formés côte à côte dans une zone de l'une des faces d'un substrat semi-isolant, et en ce que les lignes de transmission sont constituées par des dépôts conducteurs effectués sur cette face et les parties qui leur font vis-à-vis d'une électrode conductrice recouvrant la face opposée du substrat, ledit amplificateur étant en outre caractérisé en ce que la ligne d'entrée (I) comporte des dépôts conducteurs (20) alignés dans une direction, reliés aux grilles (G) des transistors, et la ligne de sortie (II) d'autres dépôts conducteurs (26) alignés dans la même direction de l'autre côté de cette zone et reliés à leurs drains (D), en ce que les réactances sont des inductances consistant en des bandes conductrices ($l_1$-$l_4$), ($l'_1$-$l'_4$) dirigées perpendiculairement à cette direction, en contact à l'une de leurs extrémités avec ces dépôts et reliées entre elles à l'autre extrémité par un conducteur (22, 24) déposé sur le substrat s'étendant parallèlement à cette direction, et caractérisé enfin en ce que les éléments de couplage consistent en des capacités ($c_1$-$c_3$), ($c'_1$-$c'_3$), disposées entre les inductances et formées par les extrémités superposées de deux dépôts conducteurs consécutifs séparés par une couche d'un matériau isolant en contact avec elles.

3. Amplificateur distribué pour hyperfréquences suivant la revendication 1, caractérisé en ce que les quadripôles actifs consistent en des transistors à effet de champ ($T_1$-$T_4$) formés côte à côte dans une zone de l'une des faces d'un substrat semi-isolant, et en ce que les lignes de transmission sont constituées par des dépôts conducteurs effectués sur cette face et les parties qui leur font vis-à-vis d'une électrode conductrice recouvrant la face opposée du substrat, ledit amplificateur étant en outre caractérisé en ce que la ligne d'entrée (I) comporte des dépôts conducteurs (20) alignés dans une direction, reliés aux grilles (G) des transistors, et la ligne de sortie (II) d'autres dépôts conducteurs (26) alignés dans la même direction de l'autre côté de cette zone et reliés à leurs drains (D), en ce que les réactances sont des inductances ($m_2$-$m_3$) constituées par les parties terminales décalées de deux dépôts conducteurs consécutifs, raccordées entre elles, de façon à délimiter une boucle, et en ce que les éléments de couplage consistent en des capacités ($F_3$, $F_4$) disposées entre les inductances et formées par des bandes conductrices dirigées perpendiculairement à cette direction, en contact à l'une de leurs extrémités avec ces dépôts et par d'autres bandes superposées aux précédentes et séparées de celles-ci par une couche en un matériau isolant, reliées entre elles par un conducteur (22-24) déposé sur le substrat s'étendant parallèlement à cette direction.

4. Dispositif d'amplification comportant un amplificateur distribué suivant l'une des revendications 1, 2, ou 3.

**Claims**

1. Distribution amplifier for hyper frequencies comprising two transmission lines, one for input and one for output (I, II) and a plurality of active four poles ($Q_1$-$Q_4$) mounted in a bypass by two of their poles on the input line (I) and by their two other poles on the output line (II), and means for adapting the four poles to each of the transmission lines, constituted by portions of the lines themselves, characterized in that the adaption means consist of reactances which form with the active four poles resonators ($C_{21}$-$C_{24}$, $L_{21}$-$L_{24}$, $L_{11}$-$L_{14}$), ($C'_{21}$-$C'_{24}$, $L'_{21}$-$L'_{24}$, $L'_{11}$-$L'_{14}$) and of coupling elements between said resonators ($L_1\gamma_1$-$L_3\gamma_3$), ($L'_1\gamma'_1$-$L'_3\gamma'_3$).

2. Distribution amplifier for hyper frequencies according to claim 1, characterized in that the active four poles consist of field effect transistors ($T_1$-$T_4$) formed side by side in a zone of one of the faces of a semi-insulating substrate, and in that the transmission lines are constituted by conducting deposits applied on said face and the portions which form their opposite side of a conducting electrode covering the opposite face of the substrate, with said amplifier being in addition characterized in that the input line (I) comprises conducting deposits (20) aligned in one direction, connected to the grids (G) of transistors, and the output line (II) comprises other conducting deposits (26) aligned in the same direction of the other side of said zone and connected at their drains (D), in that the reactances are the inductances consisting of conducting bands $(l_1-l_4)$, $(l'_1-l'_4)$ directed perpendicularly to that direction and having contact at one of their ends with said deposits and being interconnected at the other end by a conductor (22, 24) deposited on the substrate which extends parallel to said direction, and finally characterized in that the coupling elements consist of capacitances $(c_1-c_3)$, $c'_1-c'_3)$, disposed between the inductances and formed by the superimposed ends of two consecutive conducting deposits separated by a layer of insulating material in contact therewith.

3. Distribution amplifier for hyper frequencies according to claim 1, characterized in that the active four poles consist of field effect transistors $(T_1-T_4)$ formed side by side in a zone of one of the faces of the semi-insulating substrate, and in that the transmission lines are formed by conducting deposits applied on said face and the portions opposite thereto of a conducting electrode covering the face opposite the substrate, with said amplifier in addition being characterized in that the input line (I) comprises conducting deposits (20) aligned in one direction, connected to the grids (G) of the transistors, and the output line (II) comprising other conducting deposits (26) aligned in the same direction on the other side of said zone and connected with their drains (D), in that the reactances are inductances $(m_2-m_3)$ formed by the shifted terminal portions of two consecutive conducting deposits, interconnected in such a way as to define a loop, and in that the coupling elements consist of capacitances $(F_3, F_4)$ provided between the inductances and formed of conducting bands directed perpendicularly to said direction, in contact with one of their ends with their deposits, and of another band, super-imposed on the preceding ones and separated therefrom by a layer of insulating material, interconnected by a conductor (22-24) deposited on the substrate which extends parallel to said direction.

4. Amplifier device which comprises a distribution amplifier according to claims 1, 2 or 3.

## Ansprüche

1. Verteilungsverstärker für Hyperfrequenzen, die zwei Übertragungsleitungen einschliesst, eine für Eingang und eine für Ausgang (I, II) und mehrere aktive Vierpole $(Q_1-Q_4)$, im Nebenschluss mit zwei ihrer Pole auf der Eingangsleitung (I) und der zwei anderen Pole auf der Ausgangsleitung (II), und Mitteln zum Angleichen der vier Pole an jede der Übertragungsleitungen, die Teile dieser Leitungen selbst darstellen, dadurch gekennzeichnet, dass die Angleichungsmittel aus Reaktzanzen bestehen, die mit den aktiven Vierpolen Resonatoren bilden $(C_{21}-C_{24}, L_{21}-L_{24}, L_{11}-L_{14})$, $C'_{21}-C'_{24}$, $L'_{21}-L'_{24}$, $L'_{11}-L'_{14})$, und aus Verbindungsmitteln zwischen diesen Resonatoren $(L_1\gamma_1-L_3\gamma_3)$, $(L'_1\gamma'_1-L'_3\gamma'_3)$.

2. Verteilungsverstärker für Hyperfrequenzen gemäss Anspruch 1, dadurch gekennzeichnet, dass die aktiven Vierpole aus Feldeffekttransistoren $(T_1-T_4)$ bestehen, die Seite an Seite in einem Abschnitt einer der Flächen eines halb-isolierenden Substrats liegen, und dadurch, dass die Übertragungsleitungen aus leitenden Auflagen gebildet sind, die auf der genannten Fläche aufgetragen wurden und den Teilen, welche die gegenüberliegende Seite einer leitenden Elektrode bilden, welche die gegenüberliegenden Seiten des Substrats bedeckts, wobei der Verstärker zusätzlich dadurch gekennzeichnet ist, dass die Eingangsleitung (I) leitende Auflagen (20) einschliesst, die in einer Richtung ausgerichtet sind, mit dem Gitter (G) von Transistoren verbunden sind, und die Ausgangsleitung (II) andere leitende Auflagen (26) hat, die in der gleichen Richtung auf der anderen Seite der genannten Zone ausgerichtet und mit ihren Kollektoren (D) verbunden sind ; dadurch, dass die Reaktanzen induktive Blindwiderstände sind, die aus leitenden Bändern $(l_1-l_4)$, $(l'_1-l'_4)$ bestehen, die senkrecht zu dieser Richtung ausgerichtet sind und an einem ihrer Enden Kontakt mit den genannten Auflagen haben und miteinander am anderen Ende durch einen Leiter (22, 24) untereinander verbunden sind, der auf dem Substrat aufgebracht wurde, das sich parallel zu der genannten Richtung erstreckt, und schliesslich dadurch gekennzeichnet ist, dass die Verbindungsteile aus Kapazitanzen $(c_1-c_3)$, $(c'_1-c'_3)$ bestehen, die zwischen den induktiven Blindwiderständen liegen und aus den übereinanderliegenden Enden zweier aufeinanderfolgenden leitenden Auflagen bestehen, die durch eine Schicht eines isolierenden Materials getrennt werden, das in Kontakt mit ihnen ist.

3. Verteilungsverstärker für Hyperfrequenzen gemäss Anspruch 1, dadurch gekennzeichnet, dass der aktive Vierpol aus Feldeffekt-Transistoren $(T_1-T_4)$ besteht, die Seite an Seite in einer Zone auf einer der Flächen des halbisolierenden Substrats liegen, und dadurch, dass die Verbindungsleitungen aus leitenden Auflagen bestehen, die auf der genannten Seite und den dazu gegenüberliegenden Teilen einer leitenden Elektrode aufgebracht wurden, welche die gegenüberliegende Seite des Substrats bedeckt, wobei der genannte Verstärker zusätzlich dadurch gekennzeichnet ist, dass die Eingangsleitung (I) leitende Auflagen (20) einschliesst, die in einer Richtung ausgerichtet sind, mit dem Gitter (G) von Transistoren verbunden sind, und die Aus-

gangsleitung (II) andere leitende Auflagen (26) hat, die in der gleichen Richtung auf der anderen Seite der genannten Zone ausgerichtet und mit ihren Kollektoren (D) verbunden sind ; dadurch dass die Reaktanzen induktive Blindwiderstände ($m_2$-$m_3$) sind, die aus den verschobenen Polteilen der zwei aufeinanderfolgenden Auflagen bestehen, die so miteinander verbunden sind, dass sie eine Schleife bilden, und dadurch, dass die Verbindungsteile aus Kapazitanzen ($F_3$, $F_4$) bestehen, die zwischen den induktiven Blindwiderständen liegen und aus leitenden Bändern bestehen, die sich senkrecht zu der genannten Richtung erstrecken, die mit einem ihrer Enden mit ihren Auflagen verbunden sind, und aus einem anderen Band, das auf den vorgenannten aufgebracht ist und davon durch eine Schicht isolierenden Materials getrennt ist, die untereinander verbunden sind durch einen Leiter (22-24), der auf dem Substrat aufgebracht ist, das sich parallel zu der genannten Richtung erstreckt.

4. Verstärkervorrichtung, die einen Verteilungsverstärker gemäss Anspruch 1, 2 oder 3 einschliesst.

## FIG_1

## FIG_2

FIG. 3

FIG. 4

2

FIG_5

FIG_6